# EUROPÄISCHE PATENTANMELDUNG

(11) **EP 0 527 290 A1**
(43) Veröffentlichungstag der Anmeldung: **17.02.1993**
(21) Anmeldenummer: 92105177.7
(22) Anmeldetag: 26.03.1992
(51) Int. Cl.: H01J 37/32

(54) **Vorrichtung für Dünnschichtverfahren zur Behandlung grossflächiger Substrate**

(30) Priorität: 08.08.1991 DE 4126216
(71) Anmelder: LEYBOLD AKTIENGESELLSCHAFT, D-63450 Hanau (DE)
(72) Erfinder: Gegenwart, Rainer, Dr., W-6074 Rödermark (DE); Gesche, Roland, Dr., W-6453 Seligenstadt (DE); Kretschmer, Karl-Heinz, Dr., W-6054 Rodgau 2 (DE); Ritter, Jochen, Dipl.-Ing., W-6312 Laubach 1 (DE); Noll, Sonja, Namiki, Tsukuba City (JP)

(57) **Zusammenfassung**

Vorrichtung für Dünnschichtverfahren zur Behandlung großflächiger Substrate (8) unter Anwendung eines Plasmas (6), das durch Mikrowellen (M) angeregt wird und diese aus einer Quelle mittels eines Wellenleiters (W), bestehend aus mindestens einem Hohlleiter (1) , sowie einer Hornantenne (2), in eine Plasmakammer (5) eingekoppelt werden, wobei der Wellenleiter (W) eine im wesentlichen rechteckige Apertur aufweist, am Ende des Hohlleiters (Q) ein Bereich mit einer z. B. schlitzförmigen Verengung (Q) vorgesehen ist, an diesen Bereich ein Rechteckhorn (2) anschließt und zwischen der größten Apertur des Rechteckhorns (2), sowie der Plasmakammer (5) ein Kompensationsbereich (3) vorgesehen ist.

## Beschreibung

Die Erfindung betrifft eine Vorrichtung für Dünnschichtverfahren zur Behandlung großflächiger Substrate, typischerweise mit Substratabmessungen zwischen 500 - 1.000 mm mal 500 - 1.000 mm unter Anwendung eines Plasmas, das durch hochfrequente elektromagnetische Wellen, insbesondere Mikrowellen, angeregt wird und die elektromagnetischen Wellen aus einer Quelle mittels eines Wellenleiters, bestehend aus mindestens einem Hohlleiter sowie einer Hornantenne, in eine Plasmakammer eingekoppelt werden, welche durch ein für elektromagnetische Wellen durchlässiges Fenster von dem Wellenleiter getrennt ist.

Auf zahlreichen Gebieten der Technik werden sowohl in Beschichtungs- als auch Ätzanlagen Plasmaprozesse eingesetzt. Für die Erzeugung eines Plasmas können verschiedene Formen elektrischer Energie dienen. Beispielsweise ist es möglich, Gleichspannungen oder niederfrequente Wechselspannungen für die Erzeugung von Plasmen zu verwenden. Besonders vorteilhaft ist die Erzeugung von Plasma durch hochfrequente elektromagnetische Wellen, insbesondere Mikrowellen, weil hierbei unter anderem keine Elektroden benötigt werden, die verschmutzen und abgetragen werden können und weil das durch Mikrowellen erzeugte Plasma eine höhere Dichte von Ionen und Elektronen aufweist und daher auch auf höherem Druck gehalten werden kann als ein durch andere Verfahren erzeugtes Plasma.

Die von einer Mikrowellenquelle entsandten Wellen mit einer Frequenz von z.B. 2,45 GHz und einer Freiraumwellenlänge von ca. 12 cm werden üblicherweise mittels eines Wellenleiters übertragen und in einen Plasmaraum eingekoppelt, wobei der Wellenleiter in der Regel aus einem Hohlleiter und einer Antennenstruktur mit Koppelelementen oder einer Hornantenne besteht.

Es ist z.B. eine Einrichtung (OS DE 37 05 666) bekannt, die zum Herstellen eines Plasmas und zur Behandlung von Substraten darin geeignet ist. In dieser Einrichtung findet ein Mikrowellenleiter mit einem Hornstrahler (= Hornantenne) Anwendung, wobei drehbare Metallreflektoren innerhalb des Hornstrahlers und der Plasmakammer zur Beeinflussung der Feldverteilung eingesetzt werden. Die dadurch entstehende Vielzahl stehender Wellen wird auch als Multi-Mode-System bezeichnet. Durch diese Überlagerung vieler Einzelschwingungen entsteht ein Wellenfeld, das schon eine verbesserte Homogenität gegenüber der vom Hornstrahler abgestrahlten Mikrowellenkeule aufweist.

Zur Behandlung großflächiger Substrate, mit beispielsweise Substratabmessungen bis zu 1.000 auf 1.000 mm sind jedoch die Anforderungen an die Homogenität des Plasmas auf der gesamten Substratfläche weiter erhöht worden. So ist mit Nachteil festzustellen, daß die Anforderungen des Marktes an die Homogenität der mit oben genannter Einrichtung herstellbaren Schichten bezüglich Schichtdicke und Schichtzusammensetzung nicht mehr erfüllbar sind.

So liegt der Erfindung die Aufgabe zugrunde, eine Vorrichtung für die Erzeugung eines Plasmas mit Mikrowellen zu entwickeln, die für großflächige Substratabmessungen, gemäß obiger Definition, eine homogenere Leistungsverteilung der Mikrowellen und damit auch des Plasmas ermöglicht als bislang bekannte Vorrichtungen.

Ein großflächiges Substrat läßt sich in einer Koordinatenrichtung homogen behandeln, indem das Substrat linear an einer Plasmaquelle vorbeibewegt wird. Daraus folgt die Notwendigkeit, wenigstens in einer 2. Koordinatenrichtung, nämlich senkrecht zu der 1. Koordinatenrichtung, eine homogene Einkopplung der Mikrowellen zu erzeugen.

Diese Aufgabenstellung wird erfindungsgemäß gelöst, wie im Patentanspruch 1 beschrieben.

Mit Vorteil weisen die elektromagnetischen Wellen, beispielsweise Mikrowellen, beim Eintritt in die Plasmakammer eine annähernd ebene Phasenfront, sowie eine annähernd gleichförmige Amplitudenvertiefung auf.

Weitere Ausführungsmöglichkeiten und Merkmale sind in den Unteransprüchen näher beschrieben und gekennzeichnet.

Die Erfindung läßt verschiedene Ausführungsmöglichkeiten zu; eine davon ist beispielhaft in den anhängenden Figuren dargestellt, und zwar zeigen:
- Fig.1: eine erfindungsgemäße Vorrichtung mit einem Mikrowellenhohlleiter, einem Rechteckhorn und einer Plasmakammer in schematischer Darstellung, sowie
- Fig.2: eine Schnittdarstellung entlang der Längsachse X-X in Fig. 1

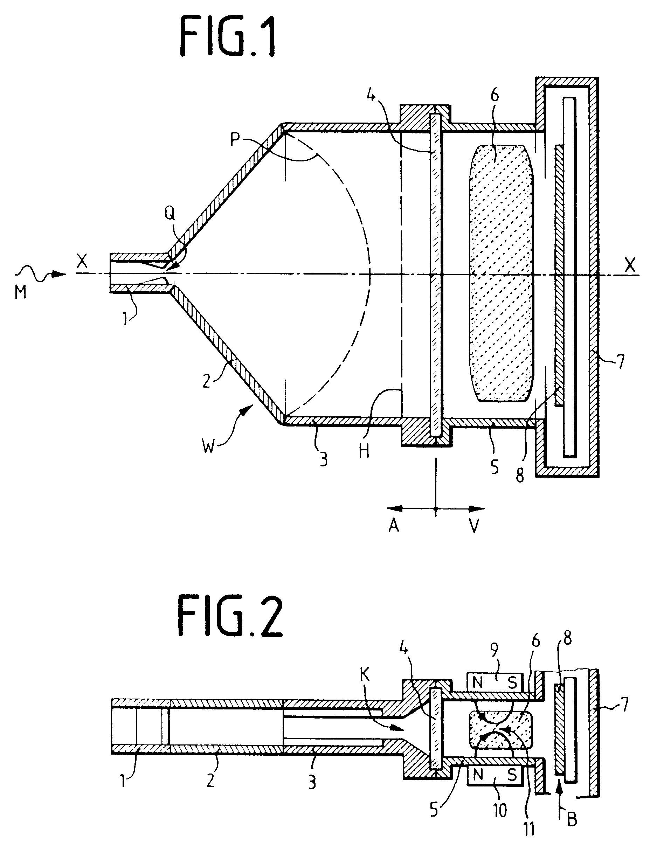

Aus einer nicht näher gezeigten Mikrowellenquelle werden die Mikrowellen M in einen Rechteckhohlleiter 1 eingespeist (Fig.1).
Dieser ist zunächst mit einer schlitzförmigen Verengung Q versehen und geht anschließend auf ein Rechteckhorn 2 über, das den Hohlleiter 1 in einer Koordinatenrichtung senkrecht zur Längsachse X-X bis zur Höhe H aufweitet. Die beiden anderen, hier nicht gezeigten Seitenwände des Horns 2, sind parallel. An das Horn 2 schließt sich ein parallel-epipeder Übergangsbereich 3 an, der durch ein ebenes Quarzfenster 4 den Bereich atmosphärischen Drucks A im Hohlleiter 1 und im Horn 2 von dem Vakuumbereich V trennt. Rechteckhohlleiter 1, Rechteckhorn 2 und der Übergangsbereich 3 bilden zusammen den Wellenleiter W.

Durch das Quarzfenster 4 gelangt die Mikrowellenstrahlung M in eine Plasmakammer 5 und führt dem hier befindlichen Plasma 6 Leistung zu. Dieser Plasmakammer 5 schließt sich eine Substratkammer 7 an, durch die das zu behandelnde Substrat 8 hindurchbewegbar ist.

Die Phasengeschwindigkeit der Mikrowelle M ist in Bereichen mit verschiedener Apertur des Wellenleiters unterschiedlich. Dadurch wird an der Verbindungsstelle zwischen Rechteckhorn 2 und Übergangsbereich 3 eine Welle mit annährend kreisbogenförmiger Phasenfront P erzeugt. Am Ende des Übergangsbereichs 3 wird die Phasenfront wieder geradlinig und eben und nimmt in etwa den Verlauf der Linie H an, so daß die Leistungsverteilung der Mikrowelle M beim Eintritt in die Plasmakammer 5 homogen ist.

Bei einem Schnitt (Fig.2) durch die oben beschriebene Vorrichtung stellt man fest, daß die Seitenwände von Hohlleiter 1 und Horn 2 parallel verlaufen. Im Übergangs- und Kompensationsbereich 3 ist zum Einen eine stufenförmige Verbreiterung der Außenkanten des Wellenleiters W zur Aufnahme des Quarzfensters 4, und zum Anderen eine trichterförmige Aufweitung K der Aperturbreite vorgesehen.
Die Plasmakammer 5 weist in einem mittleren Bereich eine Verengung auf, in welchem zwei zweipolige Magnete 9, 10 vorgesehen sind, die auf gegenüberliegenden Seiten und außerhalb der Kammer 5 angeordnet sind. In einem Magnetfeld, das durch die Magnetfeldlinien 11 der beiden Magnete 9, 10 entsteht, wird der Bereich des Plasmas 6 begrenzt. Das Substrat 8 wird vor dem Plasma 6 und in Bewegungsrichtung B durch die Substratkammer 7 hindurchbewegt. Im seitlichen Anschluß an die Kammer 7 befinden sich weitere Vakuum-Kammerbereiche, die jedoch nicht näher dargestellt sind.

### Bezugszeichenliste

- 1: Rechteckhohlleiter
- 2: Rechteckhorn, Hornantenne
- 3: Übergangs-, Kompensationsbereich
- 4: Quarzfenster
- 5: Plasmakammer
- 6: Plasma
- 7: Substratkammer
- 8: Substrat
- 9: Magnet
- 10: Magnet
- 11: Magnetfeldlinien
- M: Mikrowellen
- Q: Verengung
- H: Höhe
- A: Atmosphärischer Druckbereich
- V: Vakuumbereich
- W: Wellenleiter
- P: Phasenfront
- K: Aufweitung
- B: Bewegungsrichtung
- X-X: Längsachse, Schnitt

## Patentansprüche

1. Vorrichtung für Dünnschichtverfahren zur Behandlung großflächiger Substrate (8), typischerweise mit Substratabmessungen zwischen 500 - 1.000 mm mal 500 - 1.000 mm, unter Anwendung eines Plasmas (6), das durch hochfrequente elektromagnetische Wellen, insbesondere Mikrowellen (M), angeregt wird und die elektromagnetischen Wellen aus einer Quelle mittels eines Wellenleiters, bestehend aus mindestens einem Hohlleiter, sowie einer Hornantenne, in eine Plasmakammer (5) eingekoppelt werden, welche durch ein für elektromagnetische Wellen durchlässiges Fenster (4) von dem Wellenleiter getrennt ist, **dadurch gekennzeichnet,** daß der Wellenleiter eine im wesentlichen rechteckige Apertur aufweist, am Ende des Hohlleiters (1) ein Bereich mit einer z.B. schlitzförmigen Verengung (Q) vorgesehen ist, unmittelbar an diesen Bereich ein Rechteckhorn (2) anschließt und daß zwischen der größten Apertur des Rechteckhorns (2) sowie der Plasmakammer (5) ein Kompensationsbereich (3) vorgesehen ist, der in seiner Längs so bemessen ist, daß die elektromagnetischen Wellen, vorzugsweise Mikrowellen (M), beim Eintritt in die Plasmakammer (5) eine annährend ebene Phasenfront, die im wesentlichen parallel zur Ebene des Fensters (4) verläuft, sowie eine annährend gleichförmige Amplitudenverteilung aufweisen.

2. Vorrichtung nach Anspruch 1, **dadurch gekennzeichnet**, daß der Aufbau des Wellenleiters (W) bezüglich seiner Längsachse X-X im wesentlichen spiegelsymmetrisch ausgeführt ist.

3. Vorrichtung nach den Ansprüchen 1 oder 2, **dadurch gekennzeichnet,** daß der Wellenleiter (W) in einem Bereich zwischen dem Kompensationsbereich (3) und der Plasmakammer (5) eine vorzugsweise trichterförmige Aufweitung (K) der Apertur aufweist.

4. Vorrichtung nach den Ansprüchen 1, 2 oder 3, **dadurch gekennzeichnet**, daß die trichterförmige Aufweitung des Rechteckhorns (2), sowie die Aufweitung (K) zwischen Kompensationsbereich (3) und Plasmakammer (5) jeweils nur in einer Koordinatenrichtung senkrecht zur Längsachse X-X des Wellenleiters ausgebildet sind.

5. Vorrichtung nach Anspruch 4, **dadurch gekennzeichnet,** daß die im wesentlichen dreieckige Projektionsfläche des Rechteckhorns (2) lotrecht zu der Projektionsfläche der Aufweitung (K) angeordnet ist.
